# EUROPÄISCHE PATENTSCHRIFT

(11) **EP 3 614 154 B1**
(45) Veröffentlichungstag und Bekanntmachung des Hinweises auf die Patenterteilung: **16.10.2024**
(21) Anmeldenummer: 19188065.7
(22) Anmeldetag: 24.07.2019
(51) Int. Cl.: G01R 31/58

(54) **KABELBAUMTESTSYSTEM UND TESTVERFAHREN ZUM ÜBERPRÜFEN VON KABELBÄUMEN**
CABLE HARNESS TESTING SYSTEM AND TEST METHOD FOR TESTING CABLE HARNESSES
SYSTÈME DE FAISCEAUX DE CÂBLES ET PROCÉDÉ DE VÉRIFICATION DE FAISCEAUX DE CÂBLES

(30) Priorität: 24.08.2018 DE 102018214326
(43) Veröffentlichungstag der Anmeldung: 26.02.2020
(73) Patentinhaber: Airbus Operations GmbH, 21129 Hamburg (DE)
(72) Erfinder: Hülsen, Peter, 21129 Hamburg (DE); Yamac, Özgür, 21129 Hamburg (DE)
(74) Vertreter: Isarpatent

(56) Entgegenhaltungen:
- EP-A2- 0 450 806
- EP-A2- 0 784 210
- DE-A1- 102011 087 152
- DE-B4- 102011 087 152
- US-A- 4 951 385
- US-B1- 6 442 498

## Beschreibung

### TECHNISCHES GEBIET DER ERFINDUNG

Die Erfindung betrifft ein Kabelbaumtestsystem, insbesondere für den Einsatz in der Verkabelung von Flugzeugbauteilen während der Fertigung. Die Erfindung beschäftigt sich weiterhin mit Verfahren zum Testen von Kabelbäumen, insbesondere bei der Überprüfung von Kabelbäumen auf Funktionstüchtigkeit bei der Fertigung von Flugzeugbauteilen.

### TECHNISCHER HINTERGRUND

In heutigen modernen Flugzeugen werden viele elektrische Leitungen benötigt, die in zweckmäßiger Weise in Kabelbäumen oder Kabelsträngen in den Flugzeugbauteilen zusammengefasst werden. Dabei ist es wichtig, die Leitungen vor, nach und während der Installation in den Flugzeugbauteilen auf Funktionsfähigkeit bzw. auf eventuelle Defekte zu überprüfen. Derartige Defekte wie etwa Beschädigungen beim Einbau, fehlerhafte Verdrahtungen oder ähnliches sollten aus Gründen der Effizienz möglichst während der Fertigung festgestellt werden können.

Die Druckschrift US 5,036,479 A offenbart beispielsweise ein modularisiertes automatisches Testsystem für Avionikkomponenten während der Fertigung. Die Druckschrift DE 10 2012 200 115 A1 offenbart ein Prüfsystem für Steckverbinder in Luftfahrzeugen. Die Druckschrift US 4,218,745 A offenbart ein auf Mikrocomputern basierendes Testsystem für elektrische Kabelstränge. Die Druckschrift WO 2018/065731 A1 offenbart ein Verfahren zur Lokalisation von Defekten in elektrischen Leitungen von Flugzeugen. Die Druckschrift US 2011/0153235 A1 offenbart ein Verfahren und ein System zum Testen von elektrischen Verkabelungen komplexer Systeme. Weiterhin ist die Druckschrift DE 10 2011 087152 A1 bekannt, die ein Testsystem mit mindestens zwei Testknoten für die Prüfung mindestens einer Verbindung mit einem Stecker in einem zu testenden Kabelbaum offenbart.

### ZUSAMMENFASSUNG DER ERFINDUNG

Eine der Aufgaben der Erfindung besteht darin, Lösungen zum Testen von elektrischen Kabelbäumen in Flugzeugbauteilen zu finden, welche die Fertigungszeit der Flugzeugbauteile verringern.

Diese und andere Aufgaben werden durch ein Kabelbaumtestsystem mit den Merkmalen des Anspruchs 1 und durch ein Testverfahren zum Überprüfen von in Flugzeugbauteilen zu installierenden Kabelbäumen mit den Merkmalen des Anspruchs 4 gelöst.

Eine wesentliche Idee der Erfindung besteht darin, schwere, teure und aufwändige externe Kabelbaumteststationen durch flexible, modulare und leichte Testkits zu ersetzen, die während der Verkabelung an geeigneten Knotenpunkten der Verkabelung temporär angebracht werden können und für eine Überprüfung der Kabelbäume bzw. Kabelstränge vor, während und nach der Fertigung einzelner Flugzeugbauteile angesteuert werden können.

Ein besonderer Vorteil in der erfindungsgemäßen Lösung besteht darin, dass Produktionsengpässe durch externe Teststationen vermieden und elektrische Defekte direkt bei ihrem Auftreten erkannt werden können. Dadurch kann die Montagezeit für die Verkabelung eines Flugzeugbauteils erheblich verringert werden.

Vorteilhafte Ausgestaltungen und Weiterbildungen ergeben sich aus den weiteren Unteransprüchen sowie aus der Beschreibung unter Bezugnahme auf die Figuren.

Gemäß einigen Ausführungsformen des erfindungsgemäßen Kabelbaumtestsystems können zumindest einige der Vielzahl von Schnittstellensimulationsgeräten Mikrocomputer aufweisen. Wiederum andere der Vielzahl von Schnittstellensimulationsgeräten können in einigen Ausführungsformen des erfindungsgemäßen Kabelbaumtestsystems lediglich analoge Schaltungen aufweisen.

Gemäß einigen weiteren Ausführungsformen des erfindungsgemäßen Kabelbaumtestsystems kann das Kabelbaumtestsystem weiterhin einen Überwachungsrechner aufweisen, welcher mit dem Kabeltestgerät gekoppelt ist und dazu ausgelegt ist, von der Vielzahl von Schnittstellensimulationsgeräten an das Kabeltestgerät zurückgesendete Leitungstestsignale auszuwerten.

In manchen dieser Ausführungsformen des erfindungsgemäßen Kabelbaumtestsystems kann der Überwachungsrechner dabei dazu ausgelegt sein, in Abhängigkeit von den von der Vielzahl von Schnittstellensimulationsgeräten an das Kabeltestgerät zurückgesendeten Leitungstestsignalen Defekte oder Fehler in den Leitungen des Kabelbaums zu detektieren und an einer Ausgabeeinheit ein Informationssignal über die detektierten Defekte oder Fehler auszugeben.

Gemäß einigen Ausführungsformen des erfindungsgemäßen Testverfahrens kann das Anschließen des Kabeltestgerätes und der Vielzahl von Schnittstellensimulationsgeräten an die Vielzahl von elektrischen Leitungen des Kabelbaums nach einer Installation des Kabelbaums in dem Flugzeugbauteil erfolgen.

Gemäß einigen weiteren Ausführungsformen des erfindungsgemäßen Testverfahrens kann das Testverfahren weiterhin den Schritt des Auswertens von von der Vielzahl von Schnittstellensimulationsgeräten an das Kabeltestgerät zurückgesendeten Leitungstestsignalen durch einen Überwachungsrechner umfassen, welcher mit dem Kabeltestgerät gekoppelt ist.

Dabei kann das Auswerten des Überwachungsrechners in manchen Ausführungsformen des erfindungsgemäßen Testverfahrens ein Detektieren von Defekten oder Fehlern in den Leitungen des Kabelbaums in Abhängigkeit von den von der Vielzahl von Schnittstellensimulationsgeräten an das Kabeltestgerät zurückgesendeten Leitungstestsignalen und ein Ausgeben eines Informationssignals über die detektierten Defekte oder Fehler umfassen.

Die detektierten Defekte oder Fehler können dabei unter anderem Kabelbrüche, Kurzschlüsse, Wackelkontakte, Fehlverdrahtungen und/oder offene Leitungen sein.

Die Erfindung wird durch die beigefügten Ansprüche definiert.

### KURZE INHALTSANGABE DER FIGUREN

Die vorliegende Erfindung wird nachfolgend anhand der in den schematischen Figuren angegebenen Ausführungsbeispiele näher erläutert. Es zeigen dabei:
Fig. 1 eine Illustration eines Flugzeugs mit angedeuteten Rumpfsektionen gemäß einer Ausführungsform der Erfindung;
Fig. 2 ein schematisches Blockschaltbild eines beispielhaften Kabelbaumtestsystems innerhalb einer der Rumpfsektionen der Fig. 1 gemäß einer weiteren Ausführungsform der Erfindung; und
Fig. 3 ein Flussdiagramm eines Testverfahrens zum Überprüfen von in Flugzeugbauteilen zu installierenden Kabelbäumen gemäß einer weiteren Ausführungsform der Erfindung.

Die beiliegenden Figuren sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt. Richtungsangebende Terminologie wie etwa "oben", "unten", "links", "rechts", "über", "unter", "horizontal", "vertikal", "vorne", "hinten" und ähnliche Angaben werden lediglich zu erläuternden Zwecken verwendet und dienen nicht der Beschränkung der Allgemeinheit auf spezifische Ausgestaltungen wie in den Figuren gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG VON AUSFÜHRUNGSBEISPIELEN

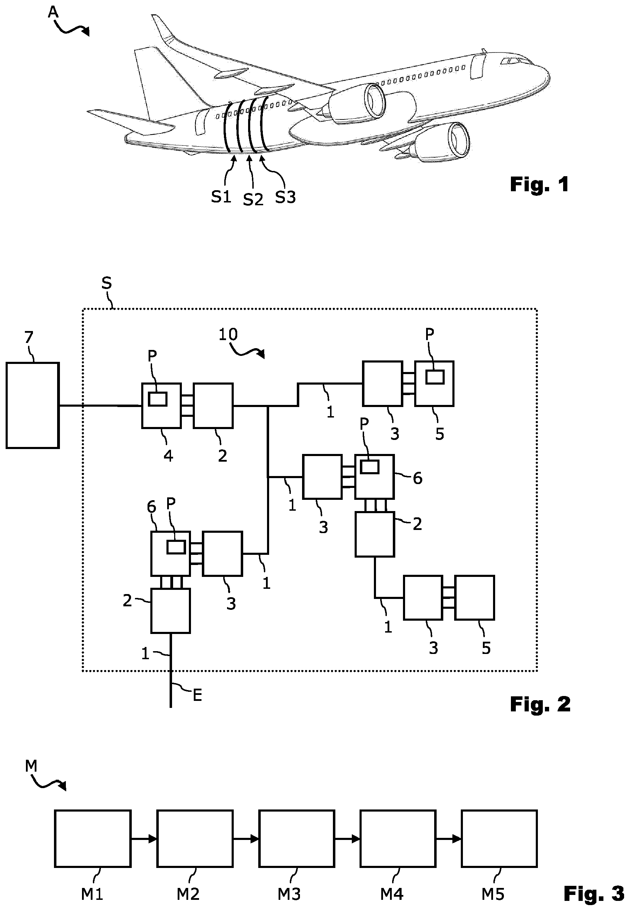

Fig. 1 zeigt eine Illustration eines Flugzeugs A, dessen Rumpf aus mehreren Rumpfsektionen S1, S2, S3 aufgebaut ist. Diese Rumpfsektionen S1 bis S3 werden üblicherweise einzeln gefertigt und in einer Endmontagelinie zu einem Rumpf des Flugzeugs A zusammengefügt. Dabei werden elektrische Leitungen, welche durch mehrere der Rumpfsektionen verlaufen, in der Endmontage durch geeignete Steckverbindungen oder Knotenelemente miteinander verbunden.

Fig. 2 zeigt ein schematisches Blockschaubild einer beispielhaften Rumpfsektion S, wie etwa eine der Rumpfsektionen S1 bis S3 der Fig. 1, in der ein Kabelbaumtestsystem 10 installiert ist. Das Kabelbaumtestsystem 10 kann während der Fertigung der Rumpfsektion S und insbesondere während und nach der

Installation eines oder mehrerer Kabelbäume zum Einsatz kommen. Das Kabelbaumtestsystem 10 dient zur Überwachung eines oder mehrerer zu installierender Kabelbäume in der Rumpfsektion S, so dass auftretende Defekte oder Fehler wie etwa Kabelbrüche, Kurzschlüsse, Wackelkontakte, Fehlverdrahtungen und/oder offene Leitungen sofort oder umgehend nach ihrem Auftreten erkannt und behoben werden können. Das Kabelbaumtestsystem 10 kann bei einem detektierten Defekt oder Fehler einem mit der Fertigung der Rumpfsektion S betrauten Person entsprechende Informationen über den Defekt oder Fehler zusammen mit einer Beschreibung des Defekts oder Fehlers und einem akustischen und/oder optischen Warnsignal ausgeben. Diese Person kann dann direkt auf den erkannten Defekt oder Fehler reagieren. Dadurch, dass der Defekt oder Fehler zeitnah bearbeitet wird, kann die Zeit bis zur Fehlerbehebung erheblich reduziert werden.

Das Kabelbaumtestsystem 10 kann während der Fertigung anderer Bereiche der Rumpfsektion S in der Rumpfsektion S verbleiben, bis die Rumpfsektion S zur finalen Abnahme bzw. zum Transport in die Endmontage bereit ist. Bis dahin kann das Kabelbaumtestsystem 10 die Funktionstüchtigkeit der Leitungen des Kabelbaums und der gesamten elektrischen Verdrahtung der Rumpfsektion S kontinuierlich überwachen. Separate Endabnahmetests mit externen Kabelbaumtestern sind durch das Kabelbaumtestsystem 10 nicht mehr zwingend notwendig.

Das Kabelbaumtestsystem 10 umfasst ein Kabeltestgerät 4 sowie mehrere Schnittstellensimulationsgeräte 5 bzw. 6. Das Kabeltestgerät 4 dient als zentrales Netzwerkelement und weist einen Mikrocomputer P zum Erzeugen, Analysieren und Weiterleiten einer Vielzahl verschiedener und an die Art der zu testenden Kabelbäume anpassbarer Leitungstestsignale auf. Über eine Vielzahl von ersten Testpunktanschlüssen können jeweils Leitungen 1 eines Kabelbaums mit ihren ersten Endpunkten 2 an das Kabeltestgerät 4 angeschlossen werden. Die ersten Endpunkte 2 können dabei über geeignete Adapter, Schnittstellenanschlüsse oder Verbinder verfügen.

Nach und nach wird eine Vielzahl von elektrischen Leitungen 1 des Kabelbaums verlegt. An den jeweiligen den ersten Endpunkten 2 gegenüberliegenden Endpunkten 3 der Leitungen werden dann Schnittstellensimulationsgeräte 5 bzw. 6 angeschlossen. Die Schnittstellensimulationsgeräte 5 bzw. 6 können dabei über zweite Testpunktanschlüsse verfügen, über die die zweiten Endpunkte 3 der Vielzahl von elektrischen Leitungen 1 des Kabelbaums angeschlossen werden können, beispielsweise über entsprechende Verbinder, Adapter oder Schnittstellenanschlüsse, je nach Art und Funktionsweise der Leitungen 1.

In Fig. 2 sind verschiedene mögliche Varianten für die Schnittstellensimulationsgeräte gezeigt. Manche der Schnittstellensimulationsgeräte 5 können ebenso wie das Kabeltestgerät 4 über einen Mikrocomputer P verfügen, welcher an den zweiten Endpunkten 3 anzuschließende Endgeräte simulieren kann. Manche der Schnittstellensimulationsgeräte 5 können allerdings lediglich analoge Schaltungen aufweisen, wie etwa Diodenschaltungen, analoge Filter oder Abschlusswiderstände, um entsprechendes elektrisches Verhalten an den zweiten Endpunkten 3 zu simulieren. Wiederum andere der Schnittstellensimulationsgeräte 6 können einen Mikrocomputer P aufweisen und dazu geeignet sein, Signale an weitere Leitungsabschnitte 1 des Kabelbaums durchzuleiten. Die Schnittstellensimulationsgeräte 6 können beispielsweise über dritte Testpunktanschlüsse verfügen, über die Leitungen 1 mit ihren ersten Endpunkten 2 angeschlossen werden können. An diese Leitungen 1 können an deren zweiten Endpunkten 3 wiederum weitere Schnittstellensimulationsgeräte, wie beispielsweise Schnittstellensimulationsgeräte 5 mit Mikrocomputern P oder lediglich mit analogen Schaltungen angeschlossen werden.

Durch das derart entstehende Netzwerk an Leitungen 1 kann das Kabeltestgerät 4 Leitungstestsignale leiten. Diese Leitungstestsignale können anpassbar durch das Kabeltestgerät 4 erzeugt werden und über die ersten Testpunktanschlüsse in die Vielzahl von elektrischen Leitungen 1 des Kabelbaums eingespeist werden. Die Schnittstellensimulationsgeräte 5, 6 empfangen jeweils eines der Leitungstestsignale über die jeweils angeschlossene der Leitungen 1 und senden jeweils geeignete Antwortsignale auf die Leitungstestsignale an das Kabeltestgerät 4 zurück. Das Zurücksenden der Leitungstestsignale kann dabei über die zweiten Testpunktanschlüssen und die entsprechenden elektrischen Leitungen 1 des Kabelbaums erfolgen.

Das Kabeltestgerät 4 kann entweder die empfangenen zurückgesendeten Leitungstestsignale selbst auswerten oder an einen Überwachungsrechner 7 weitergeben, wie etwa einen PC, einen Laptop oder ein mobiles Kommunikationsgerät. Der Überwachungsrechner 7 ist mit dem Kabeltestgerät 4 gekoppelt und kann beispielsweise außerhalb der Rumpfsektion S angeordnet werden, um einer mit der Fertigung betrauten Person einen leichteren Zugang zu den benötigten Informationen zu verschaffen. Der Überwachungsrechner 7 wertet die von den Schnittstellensimulationsgeräten 5, 6 an das Kabeltestgerät 4 zurückgesendeten Leitungstestsignale aus, beispielsweise indem in Abhängigkeit von den von den Schnittstellensimulationsgeräten 5, 6 an das Kabeltestgerät 4 zurückgesendeten Leitungstestsignalen Defekte oder Fehler in den Leitungen 1 des Kabelbaums detektiert werden. Über eine (in Fig. 2 nicht explizit dargestellte) Ausgabeeinheit des Überwachungsrechners 7 können Informationssignale über die detektierten Defekte oder Fehler an Bedienpersonen ausgegeben werden, wie etwa akustische und/oder optische Warnsignale sowie Beschreibungen und Klassifizierungen der detektierten Defekte oder Fehler.

Fig. 3 illustriert Stufen eines beispielhaften Testverfahrens M zum Überprüfen von in einem Flugzeugbauteil wie etwa einer Rumpfsektion S zu installierenden Kabelbaum. In einem ersten Schritt M1 wird ein Kabeltestgerät 4 mit einem Mikrocomputer P und einer Vielzahl von ersten Testpunktanschlüssen an erste Endpunkte 2 einer Vielzahl von elektrischen Leitungen 1 des Kabelbaums angeschlossen. In einem zweiten Schritt M2 wird dann eine Vielzahl von Schnittstellensimulationsgeräten 5, 6 mit jeweils einer Vielzahl von zweiten Testpunktanschlüssen an zweite Endpunkte 3 der Vielzahl von elektrischen Leitungen 1 des Kabelbaums angeschlossen. Dieses Anschließen des Kabeltestgerätes 4 und der Vielzahl von Schnittstellensimulationsgeräten 5, 6 kann beispielsweise nach einer vollständigen oder teilweisen Installation des Kabelbaums in dem Flugzeugbauteil S erfolgen.

Durch das Kabeltestgerät 4 werden in einem dritten Schritt M3 Leitungstestsignale in die Vielzahl von elektrischen Leitungen 1 des Kabelbaums eingespeist, welche in einem vierten Schritt M4 an der Vielzahl von Schnittstellensimulationsgeräten 5, 6 empfangen und an das Kabeltestgerät 4 durch die Vielzahl von elektrischen Leitungen 1 des Kabelbaums zurückgesendet werden. Danach kann in einem fünften Schritt M5 ein Auswerten von von der Vielzahl von Schnittstellensimulationsgeräten 5, 6 an das Kabeltestgerät 4 zurückgesendeten Leitungstestsignalen durch einen Überwachungsrechner 7 erfolgen. Der Überwachungsrechner 7 kann beispielsweise Defekte oder Fehler in den Leitungen 1 des Kabelbaums in Abhängigkeit von den von der Vielzahl von Schnittstellensimulationsgeräten 5, 6 an das Kabeltestgerät 4 zurückgesendeten Leitungstestsignalen detektieren. Weiterhin kann der Überwachungsrechner 7 Informationssignal über die detektierten Defekte oder Fehler an eine Bedienperson des Überwachungsrechners 7 ausgeben, wie etwa akustische und/oder optische Warnsignale sowie Beschreibungen und Klassifizierungen der detektierten Defekte oder Fehler, zum Beispiel detektierte Kabelbrüche, Kurzschlüsse, Wackelkontakte, Fehlverdrahtungen und/oder offene Leitungen.

In der vorangegangenen detaillierten Beschreibung sind verschiedene Merkmale zur Verbesserung der Stringenz der Darstellung in einem oder mehreren Beispielen zusammengefasst worden. Es sollte dabei jedoch klar sein, dass die obige Beschreibung lediglich illustrativer, keinesfalls jedoch beschränkender Natur ist. Sie dient der Abdeckung aller Alternativen, Modifikationen und Äquivalente der verschiedenen Merkmale und Ausführungsbeispiele. Viele andere Beispiele werden dem Fachmann aufgrund seiner fachlichen Kenntnisse in Anbetracht der obigen Beschreibung sofort und unmittelbar klar sein.

Die Ausführungsbeispiele wurden ausgewählt und beschrieben, um die der Erfindung zugrundeliegenden Prinzipien und ihre Anwendungsmöglichkeiten in der Praxis bestmöglich darstellen zu können. Dadurch können Fachleute die Erfindung und ihre verschiedenen Ausführungsbeispiele in Bezug auf den beabsichtigten Einsatzzweck optimal modifizieren und nutzen. In den Ansprüchen sowie der Beschreibung werden die Begriffe "beinhaltend" und "aufweisend" als neutralsprachliche Begrifflichkeiten für die entsprechenden Begriffe "umfassend" verwendet. Weiterhin soll eine Verwendung der Begriffe "ein", "einer" und "eine" eine Mehrzahl derartig beschriebener Merkmale und Komponenten nicht grundsätzlich ausschließen.

## Patentansprüche

1. Kabelbaumtestsystem (10), umfassend:
ein Kabeltestgerät (4), welches einen Mikrocomputer (P) und eine Vielzahl von ersten Testpunktanschlüssen zum Anschließen erster Endpunkte (2) einer Vielzahl von elektrischen Leitungen (1) eines Kabelbaums aufweist und dazu ausgelegt ist, Leitungstestsignale an den ersten Testpunktanschlüssen in die Vielzahl von elektrischen Leitungen (1) des Kabelbaums einzuspeisen, wobei die Leitungstestsignale an jeweilige Leitungen der Vielzahl von elektrischen Leitungen (1) des Kabelbaums anpassbar durch das Kabeltestgerät (4) erzeugbar sind; und
eine Vielzahl von Schnittstellensimulationsgeräten (5, 6), welche jeweils eine Vielzahl von zweiten Testpunktanschlüssen zum Anschließen zweiter Endpunkte (3) der Vielzahl von elektrischen Leitungen (1) des Kabelbaums aufweisen und jeweils dazu ausgelegt sind, von dem Kabeltestgerät (4) an den zweiten Testpunktanschlüssen empfangene Leitungstestsignale durch die Vielzahl von elektrischen Leitungen (1) des Kabelbaums an das Kabeltestgerät (4) zurückzusenden,
wobei das Kabeltestgerät (4) ferner dazu ausgelegt ist, von der Vielzahl von Schnittstellensimulationsgeräten (5, 6) an das Kabeltestgerät (4) zurückgesendete Leitungstestsignale auszuwerten.

2. Kabelbaumtestsystem (10) gemäß Anspruch 1, wobei zumindest einige der Vielzahl von Schnittstellensimulationsgeräten (5, 6) Mikrocomputer (P) aufweisen.

3. Kabelbaumtestsystem (10) gemäß einem der Ansprüche 1 und 2, wobei zumindest einige der Vielzahl von Schnittstellensimulationsgeräten (5, 6) lediglich analoge Schaltungen aufweisen.

4. Testverfahren (M) zum Überprüfen von in einem Flugzeugbauteil (S) zu installierenden Kabelbaum, umfassend:
Anschließen (M1) eines Kabeltestgerätes (4) mit einem Mikrocomputer (P) und einer Vielzahl von ersten Testpunktanschlüssen an erste Endpunkte (2) einer Vielzahl von elektrischen Leitungen (1) des Kabelbaums;
Anschließen (M2) einer Vielzahl von Schnittstellensimulationsgeräten (5, 6) mit jeweils einer Vielzahl von zweiten Testpunktanschlüssen an zweite Endpunkte (3) der Vielzahl von elektrischen Leitungen (1) des Kabelbaums,
wobei das Anschließen des Kabeltestgerätes (4) und der Vielzahl von Schnittstellensimulationsgeräten (5, 6) an die Vielzahl von elektrischen Leitungen (1) des Kabelbaums nach einer Installation des Kabelbaums in dem Flugzeugbauteil (S) erfolgt;
Einspeisen (M3) von Leitungstestsignalen in die Vielzahl von elektrischen Leitungen (1) des Kabelbaums durch das Kabeltestgerät (4);
Zurücksenden (M4) der von dem Kabeltestgerät (4) an der Vielzahl von Schnittstellensimulationsgeräten (5, 6) empfangenen Leitungstestsignale an das Kabeltestgerät (4) durch die Vielzahl von elektrischen Leitungen (1) des Kabelbaums; und
Auswerten (M5) von von der Vielzahl von Schnittstellensimulationsgeräten (5, 6) an das Kabeltestgerät (4) zurückgesendeten Leitungstestsignalen durch das Kabeltestgerät (4).

## Claims

1. Cable harness test system (10), comprising:
a cable tester (4) that has a microcomputer (P) and a multiplicity of first test point connections for connecting first ends (2) of a multiplicity of electrical lines (1) of a cable harness and is designed to feed line test signals into the multiplicity of electrical lines (1) of the cable harness at the first test point connections, the line test signals being able to be generated by the cable tester (4) in a manner adaptable to suit respective lines of the multiplicity of electrical lines (1) of the cable harness; and
a multiplicity of interface simulation devices (5, 6) that each have a multiplicity of second test point connections for connecting second ends (3) of the multiplicity of electrical lines (1) of the cable harness and are each designed to return line test signals received from the cable tester (4) at the second test point connections to the cable tester (4) by way of the multiplicity of electrical lines (1) of the cable harness,
the cable tester (4) furthermore being designed to evaluate line test signals returned to the cable tester (4) from the multiplicity of interface simulation devices (5, 6).

2. Cable harness test system (10) according to Claim 1, wherein at least some of the multiplicity of interface simulation devices (5, 6) have microcomputers (P).

3. Cable harness test system (10) according to either of Claims 1 and 2, wherein at least some of the multiplicity of interface simulation devices (5, 6) have only analogue circuits.

4. Test method (M) for checking a cable harness to be installed in an aircraft subassembly (S), comprising:
connecting (M1) a cable tester (4) having a microcomputer (P) and a multiplicity of first test point connections to first ends (2) of a multiplicity of electrical lines (1) of the cable harness;
connecting (M2) a multiplicity of interface simulation devices (5, 6), each having a multiplicity of second test point connections, to second ends (3) of the multiplicity of electrical lines (1) of the cable harness, the cable tester (4) and the multiplicity of interface simulation devices (5, 6) being connected to the multiplicity of electrical lines (1) of the cable harness after the cable harness is installed in the aircraft subassembly (S);
feeding (M3) line test signals into the multiplicity of electrical lines (1) of the cable harness by way of the cable tester (4);
returning (M4) the line test signals received from the cable tester (4) at the multiplicity of interface simulation devices (5, 6) to the cable tester (4) by way of the multiplicity of electrical lines (1) of the cable harness; and
evaluating (M5) line test signals returned to the cable tester (4) from the multiplicity of interface simulation devices (5, 6) by way of the cable tester (4).

## Revendications

1. Système de test de faisceaux de câbles (10) comprenant
un testeur de câble (4), lequel possède un micro-ordinateur (P) et une pluralité de premières bornes de point de test servant à connecter des premiers points d'extrémité (2) d'une pluralité de lignes électriques (1) d'un faisceau de câbles et est conçu pour injecter des signaux de test de ligne au niveau des premières bornes de point de test dans la pluralité de lignes électriques (1) du faisceau de câbles, les signaux de test de ligne pouvant être générés par le testeur de câble (4) de manière adaptable à des lignes respectives de la pluralité de lignes électriques (1) du faisceau de câbles ; et
une pluralité d'appareils de simulation d'interface (5, 6), lesquels comprennent respectivement une pluralité de deuxièmes bornes de point de test servant à connecter des deuxièmes points d'extrémité (3) de la pluralité de lignes électriques (1) du faisceau de câbles et sont respectivement conçus pour renvoyer les signaux de test de ligne reçus par le testeur de câble (4) au niveau des deuxièmes bornes de point de test au testeur de câble (4) à travers la pluralité de lignes électriques (1) du faisceau de câbles,
le testeur de câble (4) étant en outre conçu pour évaluer les signaux de test de ligne renvoyés au testeur de câble (4) par la pluralité d'appareils de simulation d'interface (5, 6).

2. Système de test de faisceaux de câbles (10) selon la revendication 1, au moins certains de la pluralité d'appareils de simulation d'interface (5, 6) possédant des micro-ordinateurs (P).

3. Système de test de faisceaux de câbles (10) selon les revendications 1 et 2, au moins certains de la pluralité d'appareils de simulation d'interface (5, 6) possédant uniquement des circuits analogiques.

4. Procédé de test (M) pour vérifier un faisceau de câbles à installer dans un composant d'aéronef (S), comprenant :
raccordement (M1) d'un testeur de câble (4) comprenant un micro-ordinateur (P) et une pluralité de premières bornes de points de test à des premiers points d'extrémité (2) d'une pluralité de lignes électriques (1) du faisceau de câbles ;
raccordement (M2) d'une pluralité d'appareils de simulation d'interface (5, 6) comprenant respectivement une pluralité de deuxièmes bornes de point de test à des deuxièmes points d'extrémité (3) de la pluralité de lignes électriques (1) du faisceau de câbles, le raccordement du testeur de câble (4) et de la pluralité d'appareils de simulation d'interface (5, 6) à la pluralité de lignes électriques (1) du faisceau de câbles étant effectué après une installation du faisceau de câbles dans le composant d'aéronef (S) ;
injection (M3) de signaux de test de ligne dans la pluralité de lignes électriques (1) du faisceau de câbles par le testeur de câble (4) ;
renvoi (M4) des signaux de test de ligne reçus par le testeur de câble (4) au niveau de la pluralité d'appareils de simulation d'interface (5, 6) au testeur de câble (4) par le biais de la pluralité de lignes électriques (1) du faisceau de câbles ; et
évaluation (M5), par le testeur de câble (4), des signaux de test de ligne renvoyés au testeur de câble (4) par la pluralité d'appareils de simulation d'interface (5, 6).
